# EUROPEAN PATENT APPLICATION

(11) **EP 4 826 996 A1**
(43) Date of publication of application: **21.10.2026**
(21) Application number: 26160980.4
(22) Date of filing: 26.02.2026
(51) Int. Cl.: H03F 3/45, H03F 1/02, H03F 3/19, H03G 3/30

(54) **BROADBAND DIFFERENTIAL AMPLIFIER WITH DC OFFSET CANCELLATION**

(30) Priority: 15.04.2025 US 202519179413
(71) Applicant: GlobalFoundries U.S. Inc., Malta, NY 12020 (US)
(72) Inventor: BELLAOUAR, Abdellatif, Malta, 12020 (US); ZHANG, Chi, Malta, 12020 (US)
(74) Representative: Grünecker Patent- und Rechtsanwälte PartG mbB

(57) **Abstract**

A broadband differential amplifier includes a first signal path (102) and a second signal path (104), both signal paths having an input, a plurality of stages, and an output, wherein each stage includes an inverter; and a feedback cancellation loop (106) having: feedback inputs coupled to the output of the first signal path (102) and the output of the second signal path (104), a first feedback output coupled to a first feedback node (N1) along the first signal path (102), and a second feedback output coupled to a second feedback node (N2) along the second path (104).

## Description

### TECHNICAL FILED

The present disclosure relates to differential amplifiers and, more particularly, to a differential amplifier that includes direct current (DC) offset cancellation.

### BACKGROUND

A differential amplifier is an electronic circuit that amplifies the difference between two input voltages, while rejecting any voltage that is common to both inputs. This, for example, allows the circuit to isolate and amplify a desired signal from background noise in electrically noisy environments. Due to their noise rejection capabilities, differential amplifiers are widely used in applications like instrumentation, medical electronics, and high-precision measurements.

### SUMMARY

Disclosed herein are embodiments of a differential amplifier having direct current (DC) offset cancellation.

Illustrative aspects include a broadband differential amplifier having: a first signal path and a second signal path, both signal paths having an input, a plurality of stages, and an output, wherein each stage includes an inverter. The amplifier further includes a feedback cancellation loop having: feedback inputs coupled to the output of the first signal path and the output of the second signal path, a first feedback output coupled to a first feedback node along the first signal path, and a second feedback output coupled to a second feedback node along the second path.

In certain aspects, the first signal path and the second signal path each have three stages.

In some aspects, the first feedback node is coupled between a first inverter and a second inverter in each signal path.

Other aspects may include a radio frequency (RF) communication system, comprising a differential amplifier having: a first signal path and a second signal path, both signal paths having an input, a plurality of stages, and an output, wherein each stage includes an inverter; and a feedback cancellation loop having: feedback inputs coupled to the output of the first signal path and the output of the second signal path, a first feedback output coupled to a first feedback node along the first signal path, and a second feedback output coupled to a second feedback node along the second path.

Two or more aspects described in this disclosure, including those described in this summary section, may be combined to form implementations not specifically described herein.

The details of one or more implementations are set forth in the accompanying drawings and the description below. Other features, objects and advantages will be apparent from the description and drawings, and from the claims.

### BRIEF DESCRIPTION OF THE DRAWINGS

The present disclosure will be better understood from the following detailed description with reference to the drawings, which are not necessarily drawn to scale and in which:
FIG. 1 is a schematic circuit diagram illustrating a differential amplifier that includes direct current (DC) offset cancellation, according to embodiments;
FIG. 2 is a schematic circuit diagram illustrating a feedback loop of FIG. 1, according to embodiments;
FIG. 3 is a schematic circuit diagram illustrating an inverter of FIG. 1, according to embodiments;
FIG. 4 is a schematic circuit diagram for generating a backgate bias for the circuit of FIG. 3, according to embodiments;
FIG. 5 depicts curves in a temperature / current graph, according to embodiments;
FIG. 6 is a schematic circuit diagram for generating a current based on a temperature, according to embodiments;
FIG. 7 is a schematic circuit diagram for generating a second current based on a temperature, according to embodiments; and
FIG. 8 is a schematic circuit diagram for implementing a programmable load resistor, according to embodiments.

It is noted that the drawings of the disclosure are not necessarily to scale. The drawings are intended to depict only typical aspects of the disclosure, and therefore should not be considered as limiting the scope of the disclosure. In the drawings, like numbering represents like elements between the drawings.

### DETAILED DESCRIPTION

Differential amplifiers are often subject to a differential direct current (DC) offset in which a small, unwanted DC voltage is present at the output. This offset occurs for example when both inputs are ideally supposed to be at the same potential, essentially meaning there is a non-zero output voltage even when there is no differential input signal. This offset is typically caused by slight mismatches within the amplifier circuitry. To compensate for the mismatch, present embodiments provide a differential broadband amplifier with a differential DC offset cancellation.

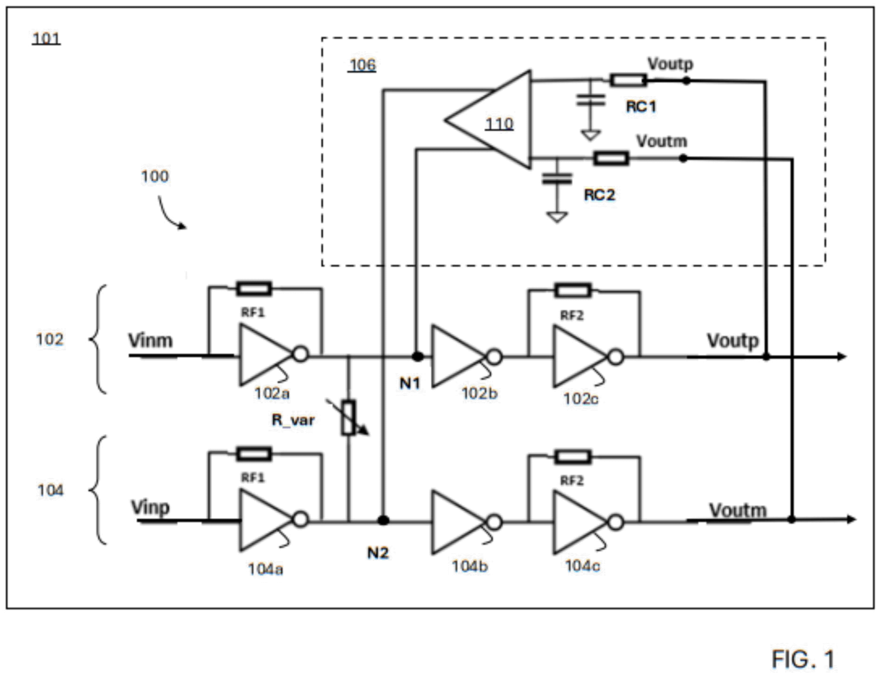

FIG. 1 depicts a differential amplifier 100 that includes two single-ended inverter-based signal paths 102, 104 in which each path includes three stages, and each stage includes an inverter. As shown, path 102 includes inverters 102a, 102b, 102c and has a negative input Vinm and a positive output Voutp. Path 104 includes inverters 104a, 104b, and 104c and has a positive input Vinp and a negative output Voutm. In this illustrative embodiment, the first stage and third stage in each path include resistors RF1, RF2, respectively, arranged in parallel with their respective inverter. Additionally, a programmable load resistor R_var, which is described in further detail herein, is coupled between the signal paths 102, 104 at the outputs of the first inverters 102a, 104a to provide gain control.

The depicted arrangement with two separate signal paths 102, 104 may be characterized as a pseudo-differential amplifier. A "pseudo-differential amplifier" is an amplifier that mimics the behavior of a true differential amplifier by using two input channels or signal paths but may not fully implement the differential signal capabilities of a standard differential amplifier. Differential amplifier 100 may for example be embodied in a system 101, e.g., a radio frequency (RF) communication system, an electronic instrument, an audio system, etc. Furthermore, system 101 may be embodied in an integrated circuit device.

Regardless, a DC offset may exist at the outputs Voutp, Voutm that can negatively impact the operation of the circuit. For example, while each output may have a similar alternating voltage swing (e.g., a 1.0 volt swing), the two outputs Voutp, Voutm, may have different DC values (e.g., 0.45 volts and 0.50 volts). To correct for this DC offset, differential amplifier 100 further includes a feedback cancellation loop 106 that injects a differential current at nodes N1, N2 based on the outputs Voutp and Voutm. In this illustrative embodiment, the differential current is injected between the first and second stages, which adds a DC voltage based on the load impedance in the circuit.

Feedback cancellation loop 106 includes a first resistor-capacitor circuit RC1 coupled to Voutp and a second resistor-capacitor circuit RC2 coupled to Voutm, which "sense" the DC voltage on each respective path 102, 104, and which provide the same to DC loop amplifier 110. DC loop amplifier 110 receives the sensed voltages of RC1 and RC2 and generates injection currents essentially opposite of the sensed DC voltages. The resulting injection currents are applied to nodes N1 and N2 to cancel the DC offset. Using feedback cancellation loop 106, the output signals Voutp and Voutm will settle with the same DC voltages (e.g., 0.475 volts) after a short period of time.

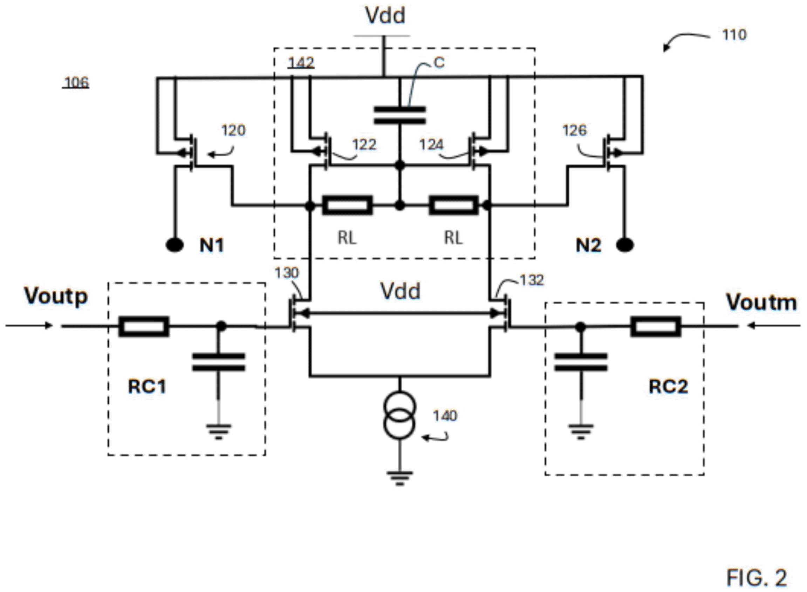

FIG. 2 depicts a detailed schematic of an illustrative feedback cancellation loop 106, which include the RC circuits (RC1, RC2) and DC loop amplifier 110. As shown, Voutp and Voutm are fed back into respective RC circuits (RC1, RC2) which as noted act as filters to sense the DC voltages. The sensed DC voltages are passed to the gates of input N-type metal oxide semiconductor (NMOS) devices 130, 132. Devices 130, 132 are coupled between a current source 140 and a current mirror 142 and are backgate biased by source voltage Vdd allowing for low voltage operations. The current mirror 142 is composed of P-type metal oxide semiconductor (PMOS) devices 122, 124 coupled to the source voltage Vdd, and an RC network formed from two load resistors (RL) and a capacitor C. Output PMOS devices 120, 126 have gates connected to the current mirror 142, and are coupled between the source voltage Vdd and injection nodes N1, N2. Additionally, all of the PMOS transistor devices 120, 122, 124, 126, are backgate biased by Vdd. The PMOS loads are accordingly self-biased with the RC network.

The resulting differential currents generated at N1 and N2 are fed back to the inputs of second stages (i.e., inverters 102b, 104b) of the differential amplifier 100 (FIG.1). The differential currents from the output PMOS devices 120, 126 provide a correcting DC voltage on each path, but have output impedances that do not affect the gain of the differential amplifier 100 due to low current injection and long channel device large of the devices.

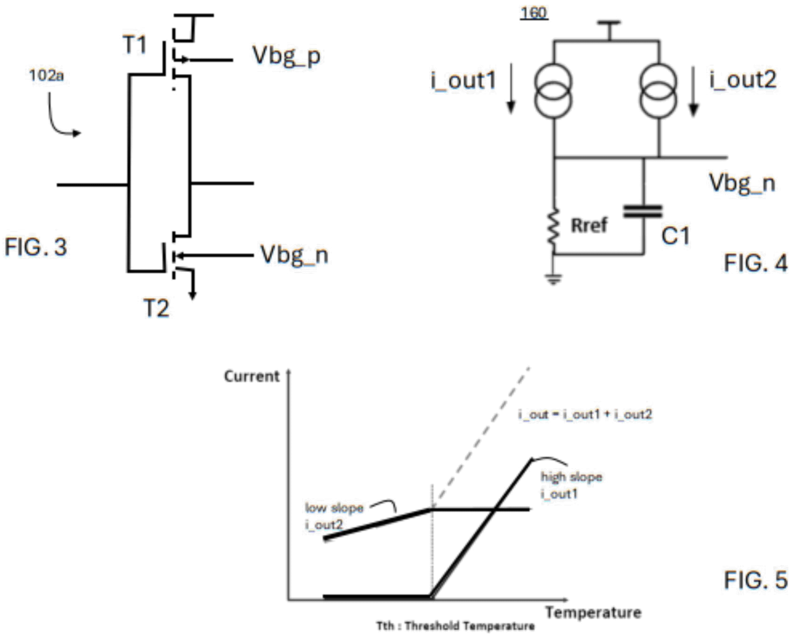

FIG. 3 depicts an embodiment of an illustrative inverter (e.g., 102a shown in FIG. 1). The inverter 102a includes an NMOS device T1 and a PMOS device T2, which are backgate biased by Vbg_p and Vbg_n, respectively. In certain embodiments, the backgate biases are used to provide temperature compensation, which allows the inverter 102a to operate differently depending on the ambient temperature. FIG. 4 depicts an illustrative circuit 160 for generating Vbg_n. The circuit 160 recieves two current sources, i_out1 and i_out2, which are coupled to an RC circuit (Rref and C1) and provides backgate bias Vbg_n. A similar circuit could be used to generate Vbg_p. FIG. 5 depicts an operational diagram of the circuit 160. At low temperatures, the current at i_out1 is zero and i_out2 ramps up with a low slope until a temperature threshold Tth is met. Once the threshold is met, the current at i_out1 ramps with a high slope and the current at i_out2 flattens. The resulting combination of i_out1 and i_out2 are shown by the dashed line (i_out).

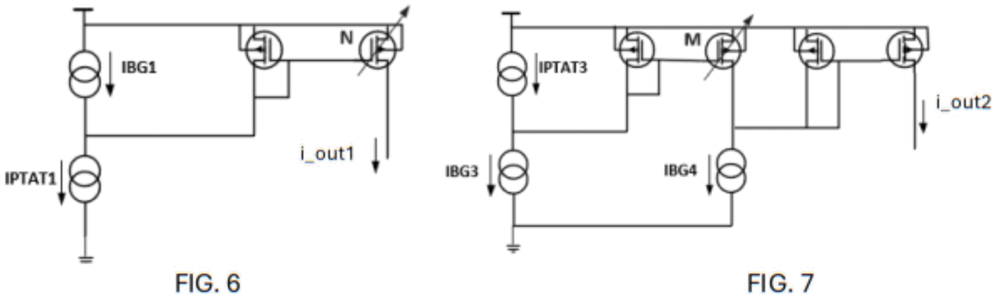

FIGS. 6 and 7 depict circuits for generating i_out1 and i_out2 to match the slopes in FIG. 5. As shown in FIG. 6, when IBG1 is greater than IPTAT1, i_out1 = 0 and the gate of PFET device N will be charged up to Vdd. When IBG1 is less than IPTAT1, i_out1 = IPTAT1-IBG1, an thus operates as a regular current mirror. i_out1 has a positive slope verses temperature and the slope only starts to rise when the temperature is higher than a certain threshold (i.e., IPTAT1 > IBG1). Note that IBG1 has constant current versus temperature, whereas IPTAT1 has a current proportional to the absolute temperature, which provides a positive slope versus temperature.

The circuit of FIG. 7 operates with a similar principle. When IPTAT3 is greater than IBG3, PFET device M is off, and i_out2 = IBG4. When IPTAT3 is less than IBG3, the current at device M (Mi) = IBG3 - IPTAT3. When Mi is greater than IBG4, i_out2 = 0. When Mi is less than IBG4, i_out2 = IBG4 - Mi = IBG4 - IBG3 + IPTAT3. Accordingly, i_out2 has a positive slope versus temperature due to IPTAT3 term. However, the slope will become zero when the temperature is higher than certain threshold (i.e., IPTAT3 < IBG3).

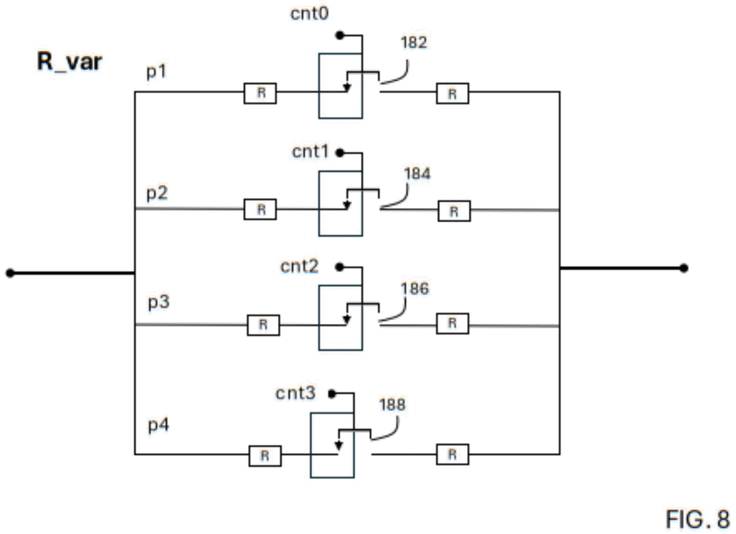

FIG. 8 depicts an illustrative programmable load resistor R_var for implementing gain control as shown in FIG. 1. In this embodiment, programmable load resistor R_var includes four control inputs cnt0...cnt3 that selectively activate a respective pair of resistors along load paths p0, p1, p2, p3. Accordingly, the amount of resistance, and therefore gain control, provided by R_var is determined by activating a switch (i.e., transistor) in one or more paths. Each control input cnt0...cnt3 is coupled to a respective transistor 182, 184, 186, 188 that turns on/off each path.

The described differential broadband amplifier is for example capable of providing a bandwidth greater than five gigahertz, a gain of more than 20 decibels, and gain control of at least 11 decibels with low-offset. Further, although generally described to operate with a supply voltage Vdd of 0.8 volts, the amplifier could be adapted to operate at higher voltage levels (e.g., 1.25 volts) using a stepped regulated voltage.

For purposes of illustration, the P-type transistors and N-type transistors may comprise metal oxide semiconductor field effect transistors (MOSFETs) and, particularly, P-type field effect transistors (PFETs) and N-type field effect transistors (NFETs), respectively. A MOSFET refers to a transistor with a semiconductor channel region positioned laterally between a source region and a drain region and with a gate (e.g., including a gate dielectric-gate conductor stack) adjacent to the channel region. However, it should be understood that the figures and discussion thereof are not intended to be limiting. For example, altematively, a similar circuit structure could be formed using bipolar junction transistors (BJTs) and, particularly, PNP BJTs and NPN BJTs.

It should be understood that the terminology used herein is for the purpose of describing the disclosed structures and methods and is not intended to be limiting. For example, as used herein, the singular forms "a," "an" and "the" are intended to include the plural forms as well, unless the context clearly indicates otherwise. Additionally, as used herein, the terms "comprises," "comprising," "includes" and/or "including" specify the presence of stated features, integers, steps, operations, elements, and/or components, but do not preclude the presence or addition of one or more other features, integers, steps, operations, elements, components, and/or groups thereof. Furthermore, as used herein, terms such as "right," "left," "vertical," "horizontal," "top," "bottom," "upper," "lower," "under," "below," "underlying," "over," "overlying," "parallel," "perpendicular," etc., are intended to describe relative locations as they are oriented and illustrated in the drawings (unless otherwise indicated) and terms such as "touching," "in direct contact," "abutting," "directly adjacent to," "immediately adjacent to," etc., are intended to indicate that at least one element physically contacts another element (without other elements separating the described elements). The term "laterally" is used herein to describe the relative locations of elements and, more particularly, to indicate that an element is positioned to the side of another element as opposed to above or below the other element, as those elements are oriented and illustrated in the drawings. For example, an element that is positioned laterally adjacent to another element will be beside the other element, an element that is positioned laterally immediately adjacent to another element will be directly beside the other element, and an element that laterally surrounds another element will be adjacent to and border the outer sidewalls of the other element. The corresponding structures, materials, acts, and equivalents of all means or step plus function elements in the claims below are intended to include any structure, material, or act for performing the function in combination with other claimed elements as specifically claimed.

The descriptions of the various disclosed embodiments have been presented for purposes of illustration but are not intended to be exhaustive or limiting. Many modifications and variations will be apparent to those of ordinary skill in the art without departing from the scope and spirit of the disclosed embodiments. The terminology used herein was chosen to best explain the principles of the embodiments, the practical application or technical improvement over technologies found in the marketplace, or to enable others of ordinary skill in the art to understand the embodiments disclosed herein.

In summary, a broadband differential amplifier is provided. The amplifier includes a first signal path and a second signal path, both signal paths having an input, a plurality of stages, and an output, wherein each stage includes an inverter; and a feedback cancellation loop having: feedback inputs coupled to the output of the first signal path and the output of the second signal path, a first feedback output coupled to a first feedback node along the first signal path, and a second feedback output coupled to a second feedback node along the second path.
The following embodiments are explicitly disclosed.
Embodiment 1: A broadband differential amplifier, comprising:
   a first signal path and a second signal path, both signal paths having an input, a plurality of stages, and an output, wherein each stage includes an inverter; and
   a feedback cancellation loop having:
      feedback inputs coupled to the output of the first signal path and the output of the second signal path,
      a first feedback output coupled to a first feedback node along the first signal path, and
      a second feedback output coupled to a second feedback node along the second path.
Embodiment 2: The broadband differential amplifier of embodiment 1, wherein the first signal path and the second signal path each have three stages.
Embodiment 3: The broadband differential amplifier of embodiment 1 or 2, wherein the first feedback node is coupled between a first inverter and a second inverter in the first signal path.
Embodiment 4: The broadband differential amplifier of one of embodiments 1 to 3, wherein the second feedback node is coupled between a first inverter and a second inverter in the second signal path.
Embodiment 5: The broadband differential amplifier of one of embodiments 1 to 4, wherein a first stage and a third stage of each signal path includes a resistor coupled in parallel with a respective inverter.
Embodiment 6: The broadband differential amplifier of one of embodiments 1 to 5, wherein the feedback cancellation loop includes a first resistor-capacitor (RC) circuit coupled to the output of the first signal path and a second RC circuit coupled to the output of the second signal path.
Embodiment 7: The broadband differential amplifier of embodiment 6, wherein the feedback cancellation loop further includes a direct current (DC) loop amplifier.
Embodiment 8: The broadband differential amplifier of embodiment 7, wherein the DC loop amplifier includes:
   a first N-type metal oxide semiconductor (NMOS) device gated by an output of the first RC circuit; and
   a second NMOS device gated by an output of the second RC circuit.
Embodiment 9: The broadband differential amplifier of embodiment 8, wherein the first NMOS device and the second NMOS device are coupled between a current source and a current mirror.
Embodiment 10: The broadband differential amplifier of embodiment 8 or 9, wherein the first NMOS device and the second NMOS device are backgate biased by a source voltage (Vdd).
Embodiment 11:
The broadband differential amplifier of embodiment 9 or 10, wherein the current mirror includes a first P-type metal oxide semiconductor (PMOS) device and a second PMOS device, each gated by an RC network.
   In some illustrative examples herein, embodiment 11 may refer to embodiment 10 and to embodiment 9.
Embodiment 12: The broadband differential amplifier of embodiment 11, wherein the first PMOS device and second PMOS device are backgate biased by Vdd.
Embodiment 13: The broadband differential amplifier of one of embodiments 9 to 12, further comprising a first output PMOS device and a second output PMOS device.
Embodiment 14: The broadband differential amplifier of embodiment 13, wherein the first output PMOS device and the second output PMOS device are gated by the current mirror.
Embodiment 15: The broadband differential amplifier of embodiment 13 or 14, wherein the first output PMOS device and the second output PMOS device are coupled between Vdd and a respective feedback node.
Embodiment 16: The broadband differential amplifier of one of embodiments 13 to 15, wherein the first output PMOS device and the second output PMOS device are backgate biased by Vdd.
Embodiment 17: The broadband differential amplifier of one of embodiments 1 to 16, further comprising a programmable load resistor coupled between the first signal path and second signal path.
Embodiment 18: The broadband differential amplifier of embodiment 17, wherein the programmable load resistor is coupled between a first and a second stage in both signal paths.
Embodiment 19: The broadband differential amplifier of embodiment 17 or 18, wherein the programmable load resistor includes a plurality of load paths, wherein each load path includes at least one resistor and a switch, and wherein the switch on each path includes a transistor gated by a control signal.
Embodiment 20. A radio frequency (RF) communication system, comprising:
   a differential amplifier having: a first signal path and a second signal path, both signal paths having an input, a plurality of stages, and an output, wherein each stage includes an inverter; and
   a feedback cancellation loop having:
      feedback inputs coupled to the output of the first signal path and the output of the second signal path,
      a first feedback output coupled to a first feedback node along the first signal path, and
      a second feedback output coupled to a second feedback node along the second path.
Embodiment 21: A radio frequency (RF) communication system, comprising the broadband differential amplifier of one of embodiments 1 to 19.

## Claims

1. A broadband differential amplifier, comprising:
a first signal path and a second signal path, both signal paths having an input, a plurality of stages, and an output, wherein each stage includes an inverter; and
a feedback cancellation loop having:
feedback inputs coupled to the output of the first signal path and the output of the second signal path,
a first feedback output coupled to a first feedback node along the first signal path, and
a second feedback output coupled to a second feedback node along the second path.

2. The broadband differential amplifier of claim 1, wherein the first signal path and the second signal path each have three stages; and/or
wherein the first feedback node is coupled between a first inverter and a second inverter in the first signal path; and/or
wherein the second feedback node is coupled between a first inverter and a second inverter in the second signal path; and/or
wherein a first stage and a third stage of each signal path includes a resistor coupled in parallel with a respective inverter.

3. The broadband differential amplifier of claim 1 or 2, wherein the feedback cancellation loop includes a first resistor-capacitor (RC) circuit coupled to the output of the first signal path and a second RC circuit coupled to the output of the second signal path.

4. The broadband differential amplifier of claim 3, wherein the feedback cancellation loop further includes a direct current (DC) loop amplifier.

5. The broadband differential amplifier of claim 4, wherein the DC loop amplifier includes:
a first N-type metal oxide semiconductor (NMOS) device gated by an output of the first RC circuit; and
a second NMOS device gated by an output of the second RC circuit.

6. The broadband differential amplifier of claim 5, wherein the first NMOS device and the second NMOS device are coupled between a current source and a current mirror.

7. The broadband differential amplifier of claim 6, wherein the current mirror includes a first P-type metal oxide semiconductor (PMOS) device and a second PMOS device, each gated by an RC network.

8. The broadband differential amplifier of claim 7, wherein the first PMOS device and second PMOS device are backgate biased by Vdd.

9. The broadband differential amplifier of one of claims 6 to 8, further comprising a first output PMOS device and a second output PMOS device.

10. The broadband differential amplifier of claim 9, wherein the first output PMOS device and the second output PMOS device are gated by the current mirror; and/or
wherein the first output PMOS device and the second output PMOS device are coupled between Vdd and a respective feedback node; and/or
wherein the first output PMOS device and the second output PMOS device are backgate biased by Vdd.

11. The broadband differential amplifier of one of claims 6 to 10, wherein the first NMOS device and the second NMOS device are backgate biased by a source voltage (Vdd).

12. The broadband differential amplifier of one of claims 1 to 11, further comprising a programmable load resistor coupled between the first signal path and second signal path.

13. The broadband differential amplifier of claim 12, wherein the programmable load resistor is coupled between a first and a second stage in both signal paths.

14. The broadband differential amplifier of claim 13, wherein the programmable load resistor includes a plurality of load paths, wherein each load path includes at least one resistor and a switch, and wherein the switch on each path includes a transistor gated by a control signal.

15. A radio frequency (RF) communication system, comprising the differential amplifier of one of claims 1 to 14.
